# EUROPEAN PATENT APPLICATION

(11) **EP 1 610 131 A1**
(43) Date of publication of application: **28.12.2005**
(21) Application number: 04388039.2
(22) Date of filing: 21.06.2004
(51) Int. Cl.: G01R 1/067

(54) **Flexible probe**

(71) Applicant: Capres A/S, 2800 Lyngby (DK)
(72) Inventor: Petersen, Peter Rasmus Ebsen, 3400 Hillerod (DK); Hansen, Jesper Erdman, 2860 Soborg (DK); Nielsen, Peter Folmer, 3520 Farum (DK)
(74) Representative: Nielsen, Henrik Sten

(57) **Abstract**

A probe for testing electric properties on a specific location of a test sample, comprises a supporting body defining opposite first and second parts constituting a flexible cantilever part being flexible in one direction and a base part, respectively. The cantilever part defines an outer planar surface substantially perpendicular to the one direction, the base part being adapted for being fixated in a co-operating testing machine. The probe further comprises at least one conductive probe arm in the cantilever part being positioned opposite the base part. The cantilever part defines opposite first and second regions, the second region being in contact with the base part, the first region defining first and second side surfaces, each of the first and second side surfaces defining a first angle with the outer planar surface, a first width defined between the first and the second side surfaces, the second region defining third and fourth side surfaces, each of the third and fourth side surfaces defining a second angle with the outer planar surface, a second width defined between the third and the fourth side surfaces, and the second width being equal to and/or smaller than the first width.

## Description

The present invention relates to probes for testing electrical properties on a specific location of a test sample. Specifically the present invention relates to test probes including a cantilever part.

Reference is made to US 5,475,318, WO 03/046473, EP 0 886 758, EP 0 974 845, EP 1 095 282 and US 2002/174715, all of the above mentioned patent publications are hereby incorporated in the present specification by reference in their entirety for all purposes.

According to a first aspect of the present invention a probe for testing electric properties on a specific location of a test sample is provided. The probe may comprise:
a supporting body defining opposite first and second parts constituting a flexible cantilever part being predominantly flexible in one direction and a base part respectively, the cantilever part defining an outer planar surface substantially perpendicular to the one direction, the base part being adapted for being fixated in a co-operating testing machine,
at least one conductive probe arm in the cantilever part, each of the at least one conductive probe arm being positioned opposite the base part,
the cantilever part defining opposite first and second regions, the second region being in contact with the base part, the first region defining first and second side surfaces, each of the first and second side surfaces defining a first angle with the outer planar surface, a first width defined between the first and the second side surfaces, the second region defining third and fourth side surfaces, each of the third and fourth side surfaces defining a second angle with the outer planar surface, a second width defined between the third and the fourth side surfaces, and
the second width being equal to and/or smaller than the first width.

The supporting body constitutes the entire probe, and may be formed as a single unitary piece or by assembling two or more pieces.

The conductive probe arms may be freely extending from the cantilever part opposite the base part thereby giving each of the conductive probe arms flexible motion. However, the conductive probe arms may alternatively be formed not extending from the cantilever part, but possibly near or at an edge of the cantilever part. The conductive probe arms may be positioned at any of the surfaces of the cantilever part.

The term predominantly flexible in one direction is to be understood as the distal part of the probe being flexible in one direction, but also flexible in other directions, so that if the probe is brought in contact with a test sample, whilst being tilted, the flexibility in multiple directions enables a perfect or near perfect alignment of the probe with the test sample.

According the teachings of the present invention the first and second side surfaces may be substantially parallel and/or the third and fourth side surfaces may be substantially parallel. The first and second sides, and correspondingly third and fourth sides, may also define an angle between them, thereby possibly giving the cantilever part a wedge form or a V-form. The first, second, third and fourth sides need not be defined in the entire area constituting the sides of the cantilever part. When producing probes of this sort, the production method includes etching which in real world applications does not product perfect planar surfaces.

According to the teachings of the present invention the first angle may be 60 to 90 degrees and/or the second angle may be approximately 60 to 90 degrees, and the first angle may be identical to or different from the second angle. The angle may be defined between any of the surfaces in any direction possible.

An object of the present invention is to provide a probe where the first region further defines a first top surface and an opposite, parallel first bottom surface, and the second region further defines a second top surface and an opposite, parallel second bottom surface, the base part defining a third top surface, the first, the second and the third top surface being substantially parallel,
the outer planar surface being constituted by the first top surface and/or the second top surface,
a first thickness defined between the first top surface and the first bottom surface,
a second thickness defined between the second top surface and the second bottom surface,
the second thickness being smaller than or equal to the first thickness.

The probe according to the teachings of the present invention may include an attenuated or thinned area in the cantilever arm. The cantilever arm may be attenuated in one, two or three dimensions, alternatively in any combinations thereof.

As previously mentioned, the physical embodiment of the present invention will not, in the mathematical sense, be precisely planer, however in the present context the substantially planar surfaces are to be construed as perfectly planar.

According to a specific feature of the present invention the second thickness may be defined across the entire second region and/or a specific part of the second region. Meaning that the area where the second region has a different thickness that the first region may be restricted to a specific area rather than the entire area. Thereby an embodiment having a specific area in the second region with either a smaller or larger thickness than the first region may be produced. The area having a different thickness is contemplated to provide flexibility to the probe.

According to a first feature of the present invention the first top surface and the second top surface may be substantially coplanar.

According to a second feature of the present invention the first top surface and the third top surface may be substantially coplanar

According to a third feature of the present invention the second top surface and the third top surface being substantially coplanar.

According to a fourth feature of the present invention none of the first, second or third top surfaces may be substantially coplanar.

According to a fifth feature of the present invention the first and the second bottom surfaces may be substantially coplanar.

The above-mentioned first, second, third, fourth and fifth features may be utilised individually or in any combinations.

It is an advantage of the present invention that the second region may include at least one aperture extending from the second top surface to the second bottom surface. Probes having one aperture may be desirable when placing may conductive probe arms in the cantilever part, since there is a need for placing electrical conductive paths from each of the conductive probe arms to a co-operating testing machine. Also a probe having one large aperture or opening may enable the sides of the connecting area to function as a hinge or the like, providing a high degree of flexibility. The aperture or apertures is contemplated to provide more flexibility to the cantilever probe. The hinge mechanism described above is also contemplated to be present in embodiments including more than one aperture and/or thinned area or areas.

It is a further advantage of the present invention that the second region may include at least one indentation, notch, depression, dent, recess, dimple or any combinations thereof, extending less than the second thickness. The indentation, cut, incision, notch, nick, dimple or serration constitutes an area or volume of the probe where material have been removed, or have never been present. The reduced amount of material is contemplated to provide more flexibility to the cantilever probe.

It is a particular advantage of the present invention that at least one of the apertures or the indentations may define an opening having a substantially circular geometry, a substantially oval geometry, a substantially square geometry, a substantially oblong geometry, a substantially triangular geometry, a truncated triangular geometry, any polygonal geometry or any combinations thereof.

According to a first object of the present invention the second region may include at lest one groove in the second top surface and/or in the second bottom surface.

According to a second object of the present invention at least one of the at least one groove may extend from the third side to the fourth side. Also the at least one groove may extend less that the second width, either from the third or fourth sides. Further alternatively the groove may extend from either the third or fourth sides in an angle in relation with the side from which the groove extends.

The groove or grooves are contemplated to provide more flexibility to the cantilever probe.

Further more at least one of the grooves may define a rounded cross-section, a square cross-section, a rectangular cross-section, a triangular cross-section, a truncated triangular cross-section, any polygonal cross-section or any combination thereof.

It is a specific advantage of the present invention that the third and/or the fourth side may include a trench extending at least partly from the second top surface to the second bottom surface or from the second bottom surface to the second top surface. Also the trench may define a rounded cross-section, a square cross-section, a rectangular cross-section, a triangular cross-section, a truncated triangular cross-section or any combination thereof. The trench or trenches are contemplated to provide more flexibility to the cantilever probe.

The trench or the groove, alternatively both the trench and the groove, may have varying depths along the path of which the groove extends. Preferably the groove or trench has substantially the same depth along the path of which it extends.

According to a specific feature of the present invention the cantilever may made from a metallic material, an alloying, a semiconductor material, a crystalline or amorphous material, or any combination thereof. Preferably, the device may be made from SiO₂, Si₃N₄, Si, is a SOI device or alternatively a layered structure comprising any of the mentioned materials.

It is an object of the present invention to include conductive paths for establishing electrical connections to each of the plurality of conductive probe arms on or in the probe. Further, the conductive paths may extend from the base part to the cantilever part of the probe. Still further, the plurality of conductive probe arms may be positioned at the outer planar surface. The outer planar surface may be any of the surfaces, e.g. the one or more of the side surfaces of the cantilever part, the bottom surface of the cantilever part or alternatively the top surface of the cantilever part. Further alternatively the plurality of conductive probe arms may be positioned/distributed at or on two or more sides, edges or surfaces at once.

The number of conductive probe arms may any, ranging from one to any number of probes possible to place on the cantilever part. The number may be limited by the space occupied by the individual conductive probe arm and the space available at the surface or edge of the cantilever part. As mentioned above, the conductive probe arms may be positioned all at one side or in any distribution among the sides. Embodiments having 2 or more probe arms are contemplated to be advantageous.

In an embodiment including more than 4 probe arms, any combination of 4 probe arms may be used to perform 4-point measurements. There is not given any preference to embodiments having even or odd number of probe arms. Generally, the co-operating testing machine may be able to address one, more or all of the conductive probe arms simultaneously. Preferably the testing machine may address any number of the conductive probe arms.

According to a sixth feature of the present invention, the first width may be 50 to 800 micron, such as 75 to 750 micron, such as 75 to 500 micron, such as 80 to 350 micron, such as 85 to 250 micron, such as 90 to 150 micron, such as 60 to 90 micron, such as 90 to 110 micron, such as 110 to 190 micron, such as 190 to 240 micron, such as 240 to 290 micron, such as 290 to 340 micron, such as 340 to 440 micron, such as 440 to 550 micron, such as 550 to 650 micron, such as 650 to 800 micron, preferably 100 micron.

According to a seventh feature of the present invention, the second width may be 40 to 300 micron, such as 50 to 250, such as 75 to 200 micron, such as 100 to 175 micron, such as 120 to 150, such as 40 to 80 micron, such as 80 to 120 micron, such as 120 to 160 micron, such as 160 to 200 micron, such as 200 to 230 micron, such as 230 to 280 micron, such as 280 to 300 micron.

According to an eight feature of the present invention, the first width may be 0,1 cm to 6 cm, such as 1 cm to 5,5 cm, such as 1,5 cm to 5 cm, such as 2 cm to 4,5 cm, such as 2,5 cm to 4 cm, such as 3 cm to 3,5 cm, such as 0,1 cm to 0,5 cm, such as 0,5 cm to 1 cm, such as 1 cm to 1,5 cm, such as 1,5 to 2 cm, such as 2 cm to 2,5 cm, such as 2,5 cm to 3 cm, such as 3 cm to 3,5 cm, such as 3,5 cm to 4 cm, such as 4 cm to 4,5 cm, such as 4,5 to 5 cm, such as 5 cm to 5,5 cm, such 5,5 cm to 6 cm. Also, the first width may be greater that 6 cm or smaller than 0,1 cm.

According to an ninth feature of the present invention, the second width may be 0,1 cm to 6 cm, such as 1 cm to 5,5 cm, such as 1,5 cm to 5 cm, such as 2 cm to 4,5 cm, such as 2,5 cm to 4 cm, such as 3 cm to 3,5 cm, such as 0,1 cm to 0,5 cm, such as 0,5 cm to 1 cm, such as 1 cm to 1,5 cm, such as 1,5 to 2 cm, such as 2 cm to 2,5 cm, such as 2,5 cm to 3 cm, such as 3 cm to 3,5 cm, such as 3,5 cm to 4 cm, such as 4 cm to 4,5 cm, such as 4,5 to 5 cm, such as 5 cm to 5,5 cm, such 5,5 cm to 6 cm. Also, the second width may be greater that 6 cm or smaller than 0,1 cm.

A probe implemented according to the eight and ninth features of the present invention may be useful when testing electrical properties of wafers comprising a number of electrical components such as transistors.

A tenth feature of the present invention relates to the cantilever part having rounded edges or corners at the distal end. This is contemplated to enable the cantilever to achieve a better alignment with the substrate on which electrical properties are to be measured.

According to a second aspect of the present invention a testing apparatus for testing electric properties on a specific location of a test sample is provided. The testing apparatus may comprise:
(a) means for receiving and supporting the test sample;
(b) electric properties testing means including electric generator means for generating a test signal and electric measuring means for detecting a measuring signal;
(c) a probe for testing electric properties on a specific location of a test sample, comprising:
   1. a supporting body defining opposite first and second parts constituting a flexible cantilever part predominantly being flexible in one direction and a base part respectively, the cantilever part defining an outer planar surface substantially perpendicular to the one direction, the base part being adapted for being fixated in a co-operating testing machine,
   2. at least one conductive probe arm in the cantilever part, each of the at least one conductive probe arm being positioned opposite the base part,
   3. the cantilever part defining opposite first and second regions, the second region being in contact with the base part, the first region defining first and second side surfaces, each of the first and second side surfaces defining a first angle with the outer planar surface, a first width defined between the first and the second side surfaces, the second region defining third and fourth side surfaces, each of the third and fourth side surfaces defining a second angle with the outer planar surface, a second width defined between the third and the fourth side surfaces,
   4. the second width being equal to and/or smaller than the first width,
(d) reciprocating means for moving the probe relative the test sample so as to cause the conductive probe arms to be contacted with the specific location of the test sample for performing the testing of electric properties thereof.

The testing apparatus according to the second aspect of the present invention basically includes a point probe according to the first aspect of the present invention, which probe, constituting a component of the point testing apparatus according to second aspect of the present invention, may be implemented in accordance with any of the above features of the probe according to the first aspect of the present invention. Furthermore, in the testing apparatus according to the second aspect of the present invention the electric properties testing means may further comprise means for electric properties probing of the test sample.

According to the teachings of the present invention the reciprocating means may further comprise holding means adapted for co-operatively receiving the base part of the probe. Also the testing apparatus may further comprise means for positioning the holding means across the test sample and recording of a location of the holding means relative to the test sample.

The means for positioning may advantageously be manoeuvrable in all spatial directions, being directions coplanar to the test sample and directions perpendicular to the test sample.

Further advantageously the means for positioning may further comprise means for angular movement of the holding means, so as to provide angular positions for the means for the probe. Even further, the means for positioning may further comprise means for angular movement of the holding means along an axis parallel to surface of the test sample, such as to provide angular positions for the means for the probe. Still further the means for positioning may even further comprise means for angular movement of the holding means along an axis perpendicular to surface of the test sample, such as to provide angular positions for the means for the probe.

According to a eleventh feature of the present invention the means for positioning further comprising means for sensing contact between the test sample and the means for the probe.

Most advantageously the probe according to the second aspect of the present invention may further include any of the features mentioned in relation to the first aspect of the present invention.

The above mentioned objects, advantages and features, will be evident, along with numerous other objects, advantages and features, from the detailed description below, where
Fig. 1 is a schematic illustration of a probe according to the present invention,
Fig. 2 is an enlarged view of a part of an alternative embodiment of a probe according to the present invention,
Fig. 3a-3c are schematic views of cross-sections of probes according to the present invention, and
Fig. 4 is a schematic view of a part of a probe according to the present invention

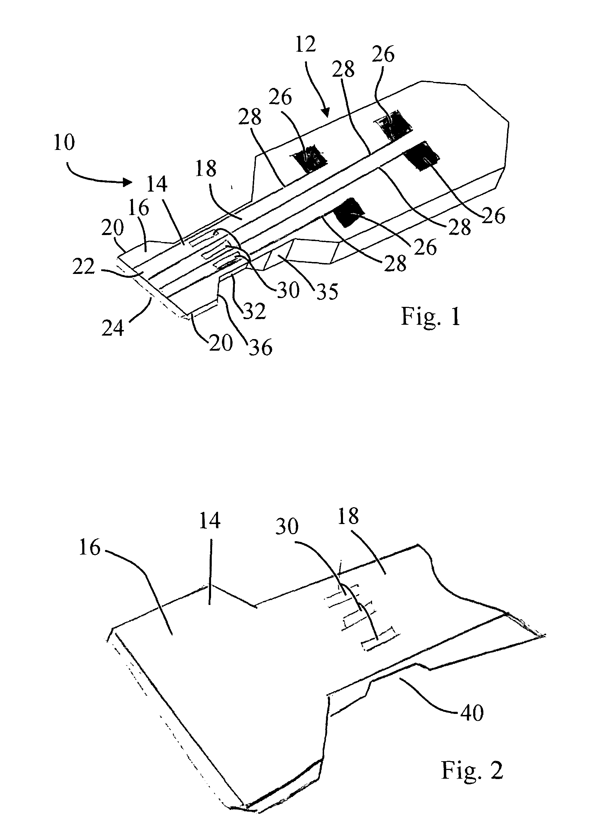

Fig. 1 is a schematic illustration of a probe 10 for testing electric properties on a specific location of a test sample. The probe body comprises two parts 12,14, constitution a base part and a flexible cantilever part respectively. The flexible cantilever part 14, comprises two regions, a distal region 16 and a connection region 18. The connection region 18 connects the cantilever part 14 with the base part 12.

In the presently preferred embodiment of the present invention the distal region 16 further comprises a plurality of conductive probe arms, not illustrated, for testing the electrical properties of a specific area on a test sample, also not illustrated. The conductive probe arms preferably extend from the top surface of the distal region 16. Alternatively, the conductive probe arms is positioned at one or more of the side surfaces 20 and/or top 22 and/or bottom 24 surfaces of the distal region 16.

For establishing electrical contact to an testing apparatus, the probe base 12 may include electrical connection pads 26, for establishing the electrical connections to the electrical conductive paths 28, that further establishes the electrical connections to the conductive probe arms.

The connection region 18 may comprise one or more areas where some of the material used to form the probe body have been removed. These areas may be constituted by one or more apertures, holes or indentations 30. The apertures 30 in Fig. 1 are illustrated as oblong apertures, however according to the teachings of the present invention, the apertures may have any geometrical configuration, such as round, square, oblong, elliptical, triangular or any polygonal geometry or combinations thereof.

The areas 30 need not be through going holes, but may be indentations, notches, depressions, dents, grooves, recesses, dimples or any combinations thereof.

Also, the connection region 18 may include areas where some of the material have been removed from the outside, such as the region designated 32 in Fig. 1. The connection region 18 may have a corresponding region on the side not illustrated in Fig. 1. The region 32 illustrated in Fig. 1, have a substantially flat surface that is perpendicular to the substantially flat surface of the connection region 18. However, the region 32 or a part hereof, may define an angle in relation to the surface of the connection region 18 different to 90 degrees, such as 45 degrees.

Part 34 of the side or bottom of the connection region 18 may define a different width than other parts of the connection region 18, such as the region 32. This thinner area enables the cantilever 14 to achieve a high degree of flexibility.

The connection region 18 and the distal part 16 may be interconnected by regions 36, 38. The regions 36, 38 may provide a better stability of the cantilever probe, but may also be omitted.

The base part 12 is preferably formed so as to fit into a co-operating receiving recess in a holder device, or the like, in a testing machine. When the probe 10 is positioned in a holder electrical connections may be established thereto via the pads 26.

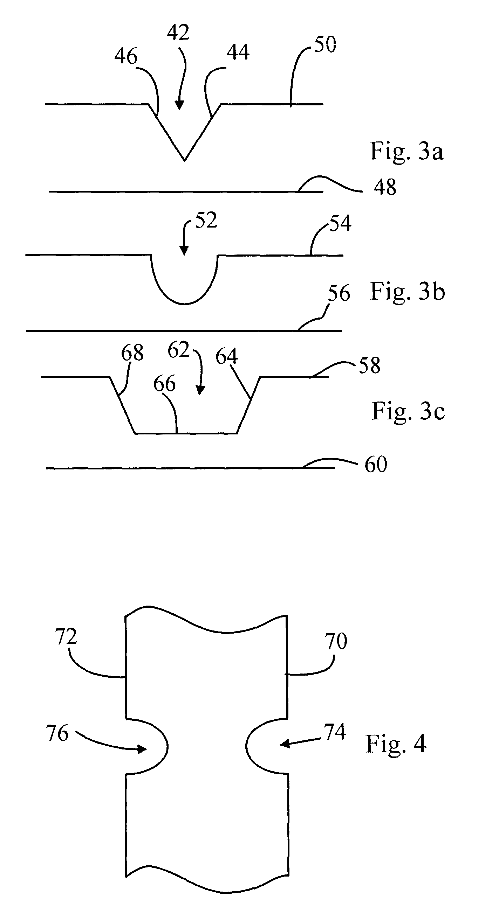

Fig. 2 is a zoomed view of the connection region 18 and the distal region 16 of an alternative embodiment the probe 10. Here an improved flexibility of the cantilever part 14 of the probe 10 is achieved by removing a part of the material across the connection region 18. In the embodiment illustrated in Fig. 2, the cut-out 40 has an truncated-triangular cross-section. Other possible cross-sections are illustrated in Figs. 3a-3c.

In both the embodiment illustrated in Fig. 1 and the embodiment illustrated Fig. 2 the number of apertures 30 are three, however, the number of apertures may be varied, from zero to as may as possible. The improved flexibility may be achieved by any of the means described above, i.e. one or more attenuated or thinned areas and/or one or more apertures.

In Fig. 3a a cross-section of a probe according to the present invention is illustrated. The probe 10 may at any surface include a indentation or cut-away area. The indentation or cut-away area may constitute the area 40 illustrated in Fig. 2, or be included in any of the surfaces of connection region 18, i.e. any of the side surfaces or top and/or bottom surfaces, also in any combinations thereof.

Fig. 3a specifically illustrates an area having a discontinuous indentation 42 in the surface 50, with a specific angle defined between the sidewalls 44, 46. The surface 48 opposite the surface 50 may also include an indentation.

Fig. 3b illustrates a surface 54 having a continuos indentation 52. The indentation 52 may have a hyperbolic or a semi-circular cross-section. The surface 56 opposite the surface 54 may also include an indentation.

Fig. 3c illustrates a surface 58 including an indentation or trench 62 defined by two sidewalls 64,68 and a bottom wall 66. The two sidewalls 64, 68 defines an angle between the two walls. The overall geometry of the trench may be substantially a truncated triangular. Provided the sidewalls 64,68 are substantially parallel, the trench will define a substantially square or oblong cross-section.

Fig. 4 illustrates a cross-section where to opposite surfaces 70,72 both include indentations 74 and 76, here illustrated as having a substantially rounded bottom. Any surface may include one or more indentations, trenches or cut-away areas.

A method for producing probes in SiO₂ according to the present invention may comprise the following sequence of steps:
a) Validation and thickness adjustment of the wafer,
b) Wet thermal wafer oxidation at 900-950 °C.
c) Front side lithography of silicon oxide pattern
d) Silicon oxide etch (anisotropic Reactive lonbeam Etch (RIE))
e) Front side lithography of trench notch pattern
f) silicon trench etching (Deep RIE)
g) Low stress silicon nitride deposition (LPCVD)
h) Back side lithography (backside alignment)
i) Backside silicon nitride etch (anisotropic RIE)
j) HF etch through back side silicon oxide
k) Wet silicon etch (KOH)
l) Front side silicon nitride etch (anisopropic RIE)
m) Front side silicon etch (isotropic RIE)
n) Metal evaporation (e-beam; static mode)

A attenuation or thinning of the cantilever or connection area may be performed between step m and n in a deep reactive ionbeam etch, DRIE, process.

A method for producing probes as SOI according to the present invention may comprise the following sequence of steps:
a) Low stress silicon nitride deposition (LPCVD)
b) Front side lithography
c) Front side silicon nitride etch (anisotropic etch)
d) Back side lithography (Back side alignment)
e) Back side silicon nitride etch (anisotropic RIE)
f) HF etch through front and back side silicon oxide
g) Wet silicon etch (KOH)
h) SiO₂ etch (bHF)
i) Front side silicon nitride etch (anisotropic RIE)
j) Monocantilever thinning (Deep RIE)
k) Electrode formation, e.g. metal evaporation and patterning.

The methods of producing the probes may be modified by persons skilled in the art.

## Claims

1. A probe for testing electric properties on a specific location of a test sample, comprising:
a supporting body defining opposite first and second parts constituting a flexible cantilever part being flexible in one direction and a base part respectively, said cantilever part defining an outer planar surface substantially perpendicular to said one direction, said base part being adapted for being fixated in a co-operating testing machine,
at least one conductive probe arm in said cantilever part, each of said at least one conductive probe arm being positioned opposite said base part,
said cantilever part defining opposite first and second regions, said second region being in contact with said base part, said first region defining first and second side surfaces, each of said first and second side surfaces defining a first angle with said outer planar surface, a first width defined between said first and said second side surfaces, said second region defining third and fourth side surfaces, each of said third and fourth side surfaces defining a second angle with said outer planar surface, a second width defined between said third and said fourth side surfaces, and
said second width being equal to and/or smaller than said first width.

2. The probe according to claim 1 wherein said first and second side surfaces being substantially parallel and/or said third and fourth side surfaces being substantially parallel.

3. The probe according to claim 1 or 2, wherein said first angle is 60 to 90 degrees and/or said second angle is approximately 60 to 90 degrees, and said first angle being identical to or different from said second angle.

4. The probe according to any of the claims 1-3, wherein said first region further defines a first top surface and an opposite, parallel first bottom surface, and said second region further defines a second top surface and an opposite, parallel second bottom surface, said base part defining a third top surface, said first, said second and said third top surface being substantially parallel,
said outer planar surface being constituted by said first top surface and/or said second top surface,
a first thickness defined between said first top surface and said first bottom surface,
a second thickness defined between said second top surface and said second bottom surface,
said second thickness being smaller than or equal to said first thickness.

5. The probe according to claim 4, wherein said second thickness is defined across all of said second regions area and/or a specific part of said second region.

6. The probe according to claim 4 or 5, wherein said first top surface and said second top surface being in substantially coplanar and/or said first top surface and said third top surface being substantially coplanar, and/or said second top surface and said third top surface being substantially coplanar, and/or none of said first, second or third top surfaces being coplanar.

7. The probe according to claim 4 or 5, wherein said first and said second bottom surfaces are substantially coplanar.

8. The probe according to any of the preceding claims, wherein
said second region includes at least one aperture extending from said second top surface to said second bottom surface.

9. The probe according to any of the preceding claims, wherein
said second region includes at least one indentation extending less than said second thickness.

10. The probe according to any of the claims 8 or 9, wherein at least one of said apertures or said indentations define an opening having a substantially circular geometry, a substantially oval geometry, a substantially square geometry, a substantially oblong geometry, a substantially triangular geometry, a truncated triangular geometry, any polygonal geometry or any combinations thereof.

11. The probe according to any of the preceding claims, wherein
said second region includes at lest one groove in said second top surface and/or in said second bottom surface.

12. The probe according to claim 11, wherein at least one of said at lest one groove extends from said third side to said fourth side.

13. The probe according to claim 11, wherein said at lest one groove extends less that said second width.

14. The probe according to any of the claims 11-13 wherein at least one of said grooves defines a rounded cross-section, a square cross-section, a rectangular cross-section, a triangular cross-section, a truncated triangular cross-section, any polygonal cross-section or any combination thereof.

15. The probe according to any of the preceding claims, wherein
said third and/or said fourth side include a trench extending at least partly from said second top surface to said second bottom surface or from said second bottom surface to said second top surface.

16. The probe according to claim 15, wherein
said trench defines a rounded cross-section, a square cross-section, a rectangular cross-section, a triangular cross-section, a truncated triangular cross-section or any combination thereof.

17. The probe according to any of the preceding claims, wherein said probe is substantially made from a metallic material, an alloying, a semiconductor material, a crystalline or an amorphous material, or any combination thereof, preferably said probe is made from SiO₂, Si₃N₄, Si, or is a SOI device or alternatively a layered structure comprising any of the mentioned materials.

18. The probe according to any of the preceding claims, wherein said probe further includes conductive paths for establishing electrical connections to each of said plurality of conductive probe arms.

19. The probe according to claim 17, wherein said conductive paths extend from said base part to said cantilever part.

20. The probe according to any of the preceding claims, wherein said plurality of conductive probe arms be positioned at said outer planar surface.

21. The probe according to any of the preceding claims, wherein
said first width being 50 to 800 micron, such as 75 to 750 micron, such as 75 to 500 micron, such as 80 to 350 micron, such as 85 to 250 micron, such as 90 to 150 micron, such as 60 to 90 micron, such as 90 to 110 micron, such as 110 to 190 micron, such as 190 to 240 micron, such as 240 to 290 micron, such as 290 to 340 micron, such as 340 to 440 micron, such as 440 to 550 micron, such as 550 to 650 micron, such as 650 to 800 micron, preferably 100 micron, and/or
said second width being 40 to 300 micron, such as 50 to 250, such as 75 to 200 micron, such as 100 to 175 micron, such as 120 to 150, such as 40 to 80 micron, such as 80 to 120 micron, such as 120 to 160 micron, such as 160 to 200 micron, such as 200 to 230 micron, such as 230 to 280 micron, such as 280 to 300 micron.

22. The probe according to any of the claims 1-20, wherein:
said first width being 0,1 cm to 6 cm, such as 1 cm to 5,5 cm, such as 1,5 cm to 5 cm, such as 2 cm to 4,5 cm, such as 2,5 cm to 4 cm, such as 3 cm to 3,5 cm, such as 0,1 cm to 0,5 cm, such as 0,5 cm to 1 cm, such as 1 cm to 1,5 cm, such as 1,5 to 2 cm, such as 2 cm to 2,5 cm, such as 2,5 cm to 3 cm, such as 3 cm to 3,5 cm, such as 3,5 cm to 4 cm, such as 4 cm to 4,5 cm, such as 4,5 to 5 cm, such as 5 cm to 5,5 cm, such 5,5 cm to 6 cm, and
said second width being 0,1 cm to 6 cm, such as 1 cm to 5,5 cm, such as 1,5 cm to 5 cm, such as 2 cm to 4,5 cm, such as 2,5 cm to 4 cm, such as 3 cm to 3,5 cm, such as 0,1 cm to 0,5 cm, such as 0,5 cm to 1 cm, such as 1 cm to 1,5 cm, such as 1,5 to 2 cm, such as 2 cm to 2,5 cm, such as 2,5 cm to 3 cm, such as 3 cm to 3,5 cm, such as 3,5 cm to 4 cm, such as 4 cm to 4,5 cm, such as 4,5 to 5 cm, such as 5 cm to 5,5 cm, such 5,5 cm to 6 cm.

23. The probe according to any of the preceding claims, wherein said cantilever part have rounded edges at the distal end.

24. A testing apparatus for testing electric properties on a specific location of a test sample, comprising:
(a) means for receiving and supporting said test sample;
(b) electric properties testing means including electric generator means for generating a test signal and electric measuring means for detecting a measuring signal;
(c) a probe for testing electric properties on a specific location of a test sample, comprising:
1. a supporting body defining opposite first and second parts constituting a flexible cantilever part being flexible in one direction and a base part respectively, said cantilever part defining an outer planar surface substantially perpendicular to said one direction, said base part being adapted for being fixated in a co-operating testing machine,
2. a plurality of conductive probe arms in said cantilever part each of said conductive probe arms freely extending from said cantilever part opposite said base part giving each of said conductive probe arms flexible motion,
3. said cantilever part defining opposite first and second regions, said second region being in contact with said base part, said first region defining first and second side surfaces, each of said first and second side surfaces defining a first angle with said outer planar surface, a first width defined between said first and said second side surfaces, said second region defining third and fourth side surfaces, each of said third and fourth side surfaces defining a second angle with said outer planar surface, a second width defined between said third and said fourth side surfaces,
4. said second width being equal to and/or smaller than said first width,
(d) reciprocating means for moving said probe relative said test sample so as to cause said conductive probe arms to be contacted with said specific location of said test sample for performing said testing of electric properties thereof.

25. The testing apparatus according to claim 24, wherein said electric properties testing means further comprising means for electric properties probing of said test sample.

26. The testing apparatus according to claim 24-25, wherein said reciprocating means further comprises holding means adapted for co-operatively receiving said base part of said probe.

27. The testing apparatus according to claim 24-26, further comprising means for positioning said holding means across said test sample and recording of a location of said holding means relative to said test sample.

28. The testing apparatus according to claim 24-27, wherein said means for positioning comprising manoeuvrability in all spatial directions, being directions coplanar to said test sample and directions perpendicular to said test sample.

29. The testing apparatus according to claim 24-28, wherein said means for positioning further comprising means for angular movement of said holding means, such as to provide angular positions for said means for said probe.

30. The testing apparatus according to claim 24-29, wherein said means for positioning further comprising means for angular movement of said holding means along an axis parallel to surface of said test sample, such as to provide angular positions for said means for said probe.

31. The testing apparatus according to claim 24-30, wherein said means for positioning further comprising means for angular movement of said holding means along an axis perpendicular to surface of said test sample, such as to provide angular positions for said means for said probe.

32. The testing apparatus according to claim 24-31, wherein said means for positioning further comprising means for sensing contact between said test sample and said means for said probe.

33. The testing apparatus according to claim 24-32, wherein said probe further includes any of the features of any of the claims 2-23.
